# EUROPEAN PATENT APPLICATION

(11) **EP 4 642 173 A1**
(43) Date of publication of application: **29.10.2025**
(21) Application number: 24747493.5
(22) Date of filing: 29.01.2024
(51) Int. Cl.: H05K 3/00, H05K 1/02, H05K 1/03, H05K 1/09, H05K 3/34

(54) **PRINTED CIRCUIT BOARD AND ELECTRONIC DEVICE COMPRISING SAME**

(30) Priority: 27.01.2023 KR 20230011090; 14.03.2023 KR 20230032933
(71) Applicant: Samsung Electronics Co., Ltd., Suwon-si, Gyeonggi-do 16677 (KR)
(72) Inventor: BANG, Jungje, Suwon-si, Gyeonggi-do 16677 (KR); KIM, Byeongkeol, Suwon-si, Gyeonggi-do 16677 (KR); KIM, Wonseob, Suwon-si, Gyeonggi-do 16677 (KR); PARK, Yisu, Suwon-si, Gyeonggi-do 16677 (KR); SEO, Hoyeon, Suwon-si, Gyeonggi-do 16677 (KR); LEE, Jongbum, Suwon-si, Gyeonggi-do 16677 (KR); JUNG, Kisoo, Suwon-si, Gyeonggi-do 16677 (KR); CHI, Yunoh, Suwon-si, Gyeonggi-do 16677 (KR)
(74) Representative: HGF
(86) International application number: PCT/KR2024/001325
(87) International publication number: WO 2024/158260

(57) **Abstract**

Disclosed are a printed circuit board and an electronic device comprising same. An electronic device according to various embodiments of the present invention comprises a substrate part on which at least one electrical component is disposed, wherein the substrate part may comprise: a printed circuit board comprising a metal wiring layer and a polymer base layer laminated on at least one side of the metal wiring layer and hot-formed to have a curved shape; and a bonding layer that comprises a solder for electrically bonding the electrical component to at least a portion of the metal wiring layer, and secures the electrical component on the substrate part.

## Description

### [Technical Field]

Various embodiments disclosed herein relate to an electronic device and, more particularly, to a printed circuit board and an electronic device including the same.

### [Background Art]

With the advancement of digital technology, various types of electronic devices such as mobile communication terminals, smartphones, tablet PCs, and wearable electronic devices are widely used. Such electronic devices are continuously being improved in hardware and/or software portions thereof for supporting and enhancing the functions thereof.

An electronic device may be connected to various other electronic devices using short-range wireless communication such as Bluetooth or Wi-Fi Direct. Such electronic devices may include headphones, earphones, smart rings, wearable earrings, and wearable display devices (e.g., AR glasses or head-mounted devices (e.g., head-mounted displays (HMDs)). Such electronic devices with various form factors may have an external appearance that includes various curves and/or curved surfaces so as to be wearable on a user's body.

An electronic device may include various electrical components such as a processor, an IC, a sensor, and/or a battery. The electronic device may include various circuit boards configured to arrange various electrical components thereon and to electrically connect the electrical components to each other.

The above-described information may be provided as related art for the purpose of helping to understand the disclosure. No claim or determination is made regarding whether any of the foregoing may be applied as prior art with respect to the disclosure.

### [Disclosure of Invention]

### [Technical Problem]

A board unit of various electronic devices having a curved outer shape may include a flexible circuit board so as to conform to the curved shape of the electronic device. For example, the board unit may include a rigid printed circuit board (rigid PCB) and a flexible printed circuit board (FPCB), and the flexible printed circuit board portion may be bent, allowing the board unit to be deformed to match the shape of the electronic device. However, such a rigid-flex printed circuit board has limited bendable areas, making it difficult to effectively utilize the internal space of the electronic device. In addition, since various electrical components may be placed only on the rigid printed circuit board portion of the rigid-flex printed circuit board, the area occupied by the board unit may not be effectively utilized.

Various embodiments of the disclosure may provide an electronic device in which the space occupied by a board unit is reduced.

According to various embodiments of the disclosure, an electronic device includes a board unit on which at least one electrical component is placed. The board unit may include a printed circuit board including a metal wiring layer and a polymer substrate layer laminated on at least one surface of the metal wiring layer, the polymer substrate layer being hot-shaped to have a curved shape, and a bonding layer configured to fix the electrical component on the board unit and to electrically bond the electrical component to at least a portion of the metal wiring layer.

In various embodiments, the polymer substrate layer may include a polymer material having a glass transition temperature lower than a melting temperature of the solder.

In various embodiments, the polymer substrate layer may include a liquid crystal polymer (LCP) material.

In various embodiments, the printed circuit board may include a built-up PCB formed by laminating at least one resin coated copper (RCC) foil.

In various embodiments, the bonding layer may include a solder configured to electrically bond the electrical component to the metal wiring layer and a resin layer configured to fix the electrical component on the board unit.

In various embodiments, the bonding layer may be formed of an alignable self-assembly (ASA) film including the resin layer and solder alloy particles dispersed in the resin layer.

In various embodiments, the ASA film may include at least one of a flux and a surfactant.

According to another aspect of the disclosure, a method of manufacturing a board unit having a curved shape for an electronic device may include a board preparation operation of placing a bonding layer including a solder and a resin layer on a printed circuit board including a polymer substrate layer and a wiring layer, a placement operation of placing an electrical component of the electronic device on the printed circuit board on which the bonding layer is placed, a hot-shaping operation of hot-shaping the printed circuit board on which the electrical component is placed into the curved shape, and a secondary heating operation of heating the printed circuit board subjected to the hot-shaping operation.

In various embodiments, the hot-shaping operation may be performed at a temperature equal to or higher than a glass transition temperature of the polymer substrate layer and lower than a melting temperature of the solder.

In various embodiments, the hot-shaping operation may be performed at a temperature ranging from 80°C to 150°C.

In various embodiments, the secondary heating operation may be performed at the melting temperature of the solder.

In various embodiments, the board preparation operation may include an operation of placing an alignable self-assembly (ASA) film on the printed circuit board.

In various embodiments, the board preparation operation may include an operation of forming the solder on the printed circuit board through pre-soldering, and an operation of forming the resin layer on the printed circuit board.

Various embodiments of the disclosure provides a board unit having a curved shape and configured to place an electrical component thereon. The board unit is positioned within an electronic device and may include a printed circuit board including a metal wiring layer and a polymer substrate layer laminated on at least one surface of the metal wiring layer, the polymer substrate layer being hot-shaped to have a curved shape, and a bonding layer configured to fix the electrical component on the board unit and to electrically bond the electrical component to at least a portion of the metal wiring layer.

According to various embodiments disclosed herein, by hot-shaping the board unit on which an electrical component is placed to have a curved shape, the internal space of an electronic device having a curved shape may be effectively utilized, and the area of the board unit may be reduced since a separate flexible board portion is not included.

The effects that are capable of being obtained by the disclosure are not limited to those described above, and other effects not described above may be clearly understood by a person ordinarily skilled in the art to which the disclosure belongs based on the following description.

### [Brief Description of Drawings]

In connection with the description of the drawings, the same or similar components may be denoted by the same or similar reference numerals.
FIG. 1 is a block diagram of an electronic device according to various embodiments in a network environment.
FIG. 2A is a perspective view of an electronic device according to various embodiments.
FIG. 2B is a cross-sectional view of the electronic device according to various embodiments.
FIG. 3 is an enlarged cross-sectional view illustrating a board unit according to various embodiments of the disclosure.
FIG. 4A is a flowchart illustrating a method of manufacturing the board unit according to various embodiments of the disclosure.
FIGS. 4B and 4C are schematic views illustrating a manufacturing process of the board unit according to various embodiments of the disclosure.
FIG. 4D is an enlarged view illustrating an operation in the manufacturing process of the board unit according to various embodiments of the disclosure.
FIG. 5 illustrates plan views of board units of electronic devices according to an embodiment of the disclosure and a comparative example.
FIG. 6 illustrates enlarged cross-sectional views of the electronic devices according to an embodiment of the disclosure and an comparative example.

### [Mode for the Invention]

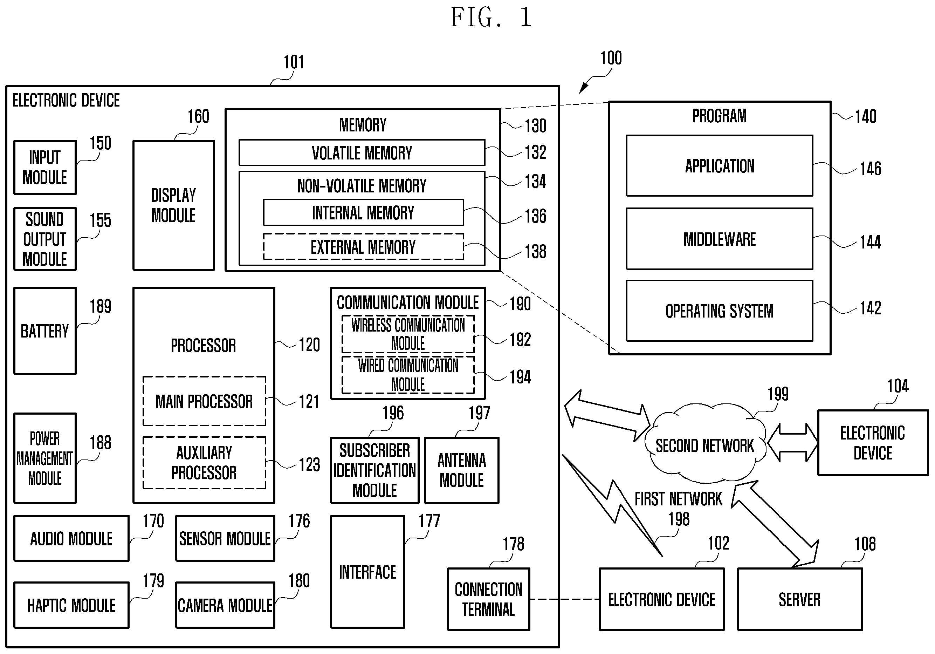

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

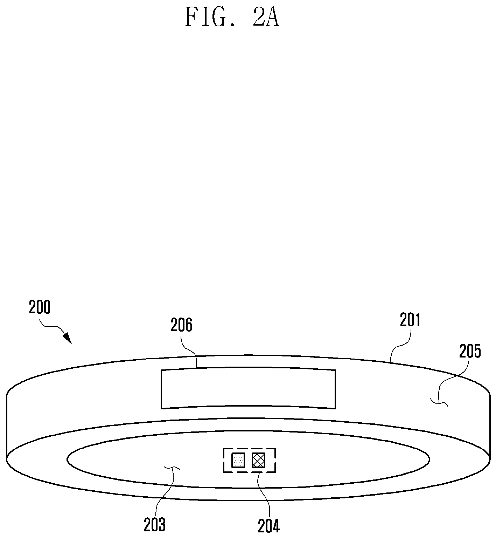

FIG. 2A is a perspective view of an electronic device according to various embodiments.

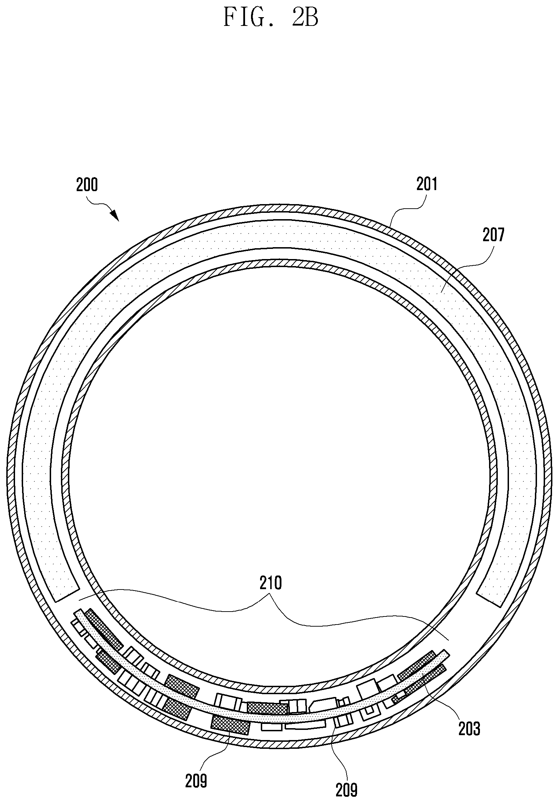

FIG. 2B is a cross-sectional view of the electronic device according to various embodiments.

Referring to FIGS. 2A and 2B, an electronic device 200 (e.g., the electronic device 101 of FIG. 1) may include a finger-wearable device (e.g., a smart ring). However, the disclosure is not limited thereto, and various types of electronic devices having a curved shape may fall within the scope of the electronic device 200 of the disclosure. For example, the electronic device 200 according to various embodiments may be implemented as various types of wearable devices such as body-attachable devices (e.g., health patches and digital tattoos), clothing-type devices (e.g., smart clothing and gloves), or band-type devices (e.g., wrist/arm/finger bands and smart rings).

As illustrated in FIGS. 2A and 2B, the electronic device 200 may include a housing 201. The housing 201 may have a curved shape, such as a ring shape, as illustrated, so as to surround at least a part of the user's body when worn, thereby preventing the housing 201 from being detached according to movement of the object to be measured.

According to various embodiments, the housing 201 may include a first surface 203 (e.g., an inner surface that comes into contact with a part of the user's body when worn) and a second surface 205 (e.g., an outer surface that is visually exposed to the outside when worn). In some embodiments, a bio-sensor unit 204 may be positioned on the first surface 203 of the housing 201. In some embodiments, a display 206 may be positioned on the second surface 205.

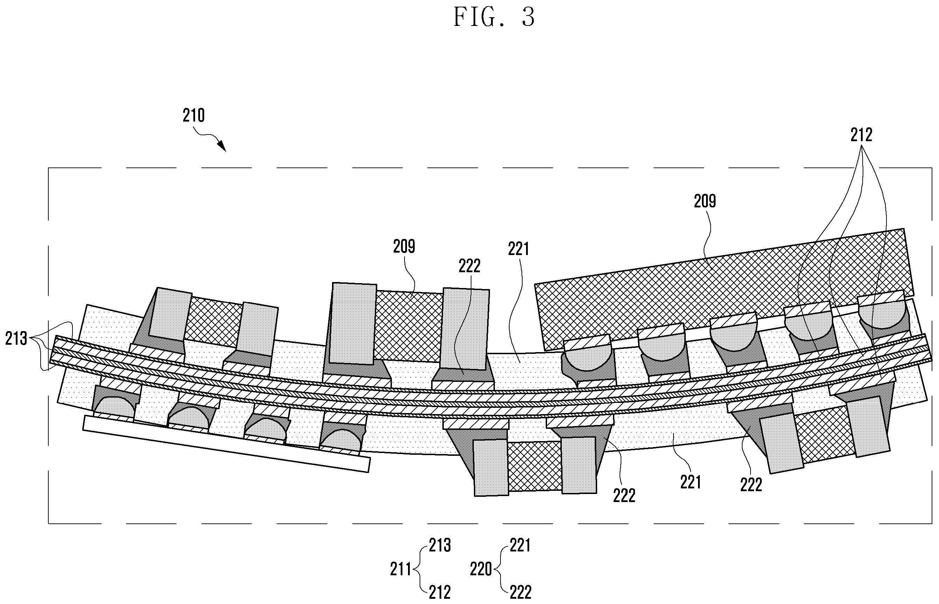

According to various embodiments, the electronic device 200 may include a board unit 210. The board unit 210 may include a printed circuit board 211 configured to place at least one electrical component 209 of the electronic device 200 thereon. The electrical component 209 may include, for example, an active element such as a processor (e.g., the processor 120 of FIG. 1), a display driver IC (DDI), a power management IC (PMIC), or a communication module, and/or a passive element such as a capacitor, an inductor, a resistor, an antenna, or a rectifier. The printed circuit board 211 may include at least one wiring layer (e.g., the wiring layer 212 of FIG. 3) including wires formed of a metal material (e.g., a thin copper film) and a polymer substrate layer (e.g., the polymer substrate layer 213 of FIG. 3). Details of the configuration of the board unit 210 will be described later.

In various embodiments, the electronic device 200 may include a battery 207 positioned within the housing 201. The battery 207 may be configured to supply power to at least one display 206, bio-sensor unit 204, and/or electrical component 209. In various embodiments, the battery 207 may have a curved shape conforming to the shape of the housing 201.

FIG. 3 is an enlarged cross-sectional view illustrating the board unit 210 according to various embodiments of the disclosure.

Referring to FIG. 3, the board unit 210 may include a printed circuit board 211 and a bonding layer 220 that bonds one or more electrical components 209 to the printed circuit board 211.

In various embodiments, the printed circuit board 211 may include at least one wiring layer 212 and at least one polymer substrate layer 213. The wiring layer 212 may be a patterned conductive layer that connects electrical components 209 to each other, and may include a patterned metal layer formed, for example, by etching a thin film of metal such as copper. The polymer substrate layer 213 may be a layer laminated on the wiring layer 212 to support the wiring layer 212. In various embodiments, the polymer substrate layer 213 may have a curved shape so as to be positioned within a curved housing. For example, the polymer substrate layer 213 may have a curved shape through hot-shaping.

In various embodiments, the polymer substrate layer 213 may include a thermoplastic polymer material capable of being hot-shaped. In some embodiments, the polymer substrate layer 213 may have a glass transition temperature Tg lower than the melting temperature of a solder 222, which will be described later. For example, the polymer substrate layer 213 may include a polymer material having a glass transition temperature Tg ranging from 80°C to 150°C. In some embodiments, the polymer substrate layer 213 may include a liquid crystal polymer (LCP) material. The LCP material may have a thermal expansion coefficient similar to that of the metal material of the wiring layer 212, and thus may exhibit high dimensional stability during heat treatment.

In various embodiments, the printed circuit board 211 may be a laminated PCB (e.g., a built-up PCB) formed by laminating a resin coated copper (RCC) foil. Compared to a general rigid PCB manufactured by laminating prepreg, the RCC foil has a thinner resin layer forming the polymer substrate layer 213, a higher resin content ratio than that of the prepreg, and a lower elastic modulus, and therefore, a built-up PCB with a laminated RCC foil may be suitable for hot-shaping into a curved shape. The polymer substrate layer 213 of the RCC foil may include various thermoplastic resins. In other embodiments, the polymer substrate layer 213 of the RCC foil may include a thermosetting resin (e.g., an epoxy resin of various compositions) that is cured through heat treatment.

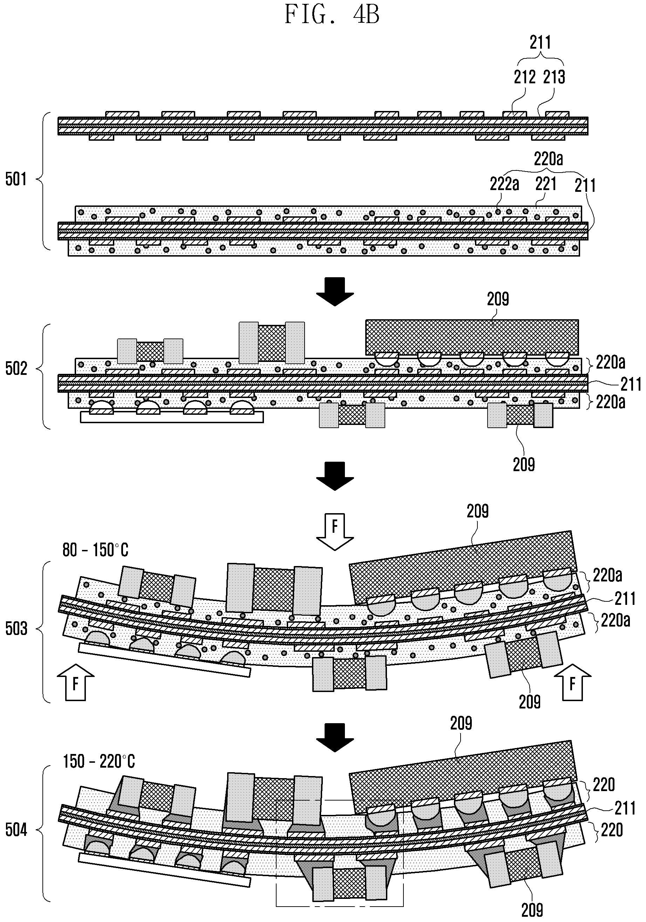

In various embodiments, the bonding layer 220 may include a solder 222 that electrically bonds the electrical components 209 to the wiring layer 212 of the printed circuit board 211. The solder 222 may be a portion that fixes the electrical components 209 to a surface of the printed circuit board 211. The solder 222 may include a solder alloy that is melted at a low temperature and contains at least one of various alloy materials such as tin, zinc, indium, copper, lead, silver (Ag), bismuth, or antimony. In various embodiments, the solder 222 may be formed of an alignable self-assembly (ASA) film 220a in which solder alloy particles (e.g., solder alloy particles 222a of FIG. 4B) are dispersed within a resin material, or may be formed on the printed circuit board 211 by pre-soldering before placement of the electrical components 209. In other embodiments, the solder 222 may also be formed by applying a solder paste by using a dispenser.

In various embodiments, the bonding layer 220 may include a resin layer 221 configured to fix the electrical components 209 to a surface of the printed circuit board 211. The resin layer 221 may include various thermoplastic and/or thermosetting resins and curing agents that are cured during a heat treatment process of the printed circuit board 211. The resin layer 221 may include various additives, such as a flux and/or a surfactant, which promote formation, alignment, and electrical bonding of the solder 222 in a molten state. In various embodiments, the resin layer 221 may be formed of an alignable self-assembly (ASA) film (e.g., the ASA film 220a of FIG. 4B) in which solder alloy particles 222a are dispersed within a resin matrix. In other embodiments, the resin layer 221 may include a film that includes a resin, a curing agent, and an additive and is placed on the printed circuit board 211.

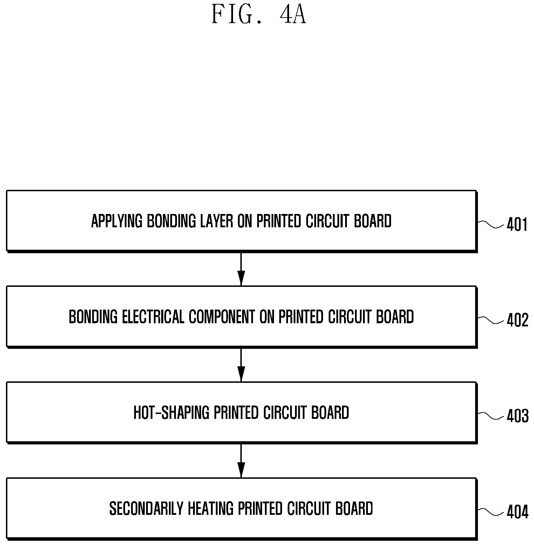

FIG. 4A is a flowchart illustrating a method of manufacturing the board unit 210 according to various embodiments of the disclosure.

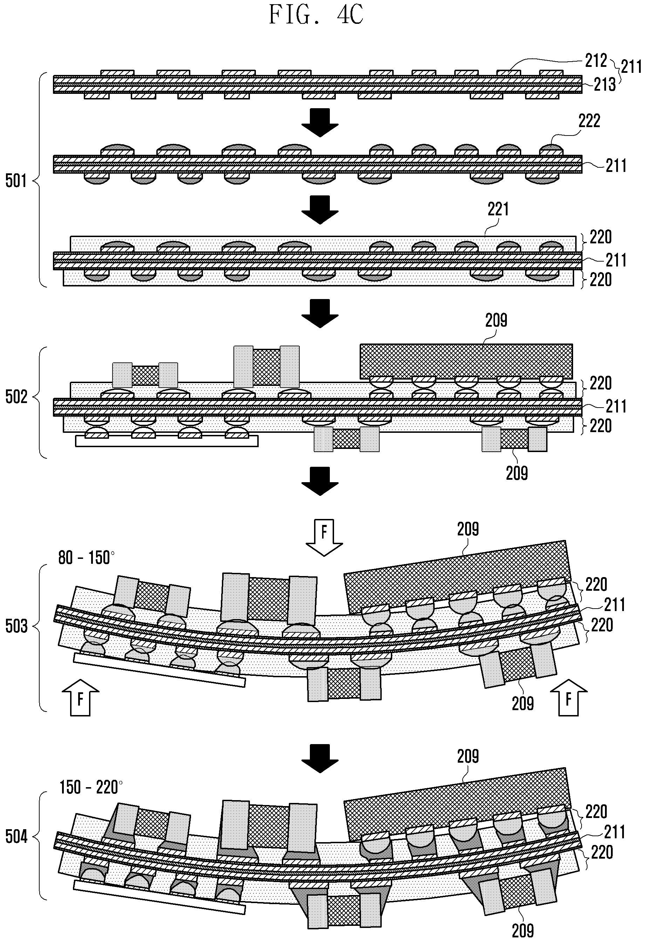

FIGS. 4B and 4C are schematic views illustrating a manufacturing process of the board unit 210 according to various embodiments of the disclosure.

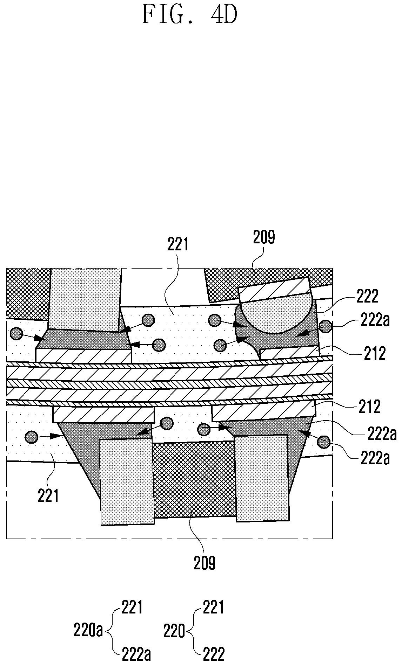

FIG. 4D is an enlarged view illustrating an operation in the manufacturing process of the board unit 210 according to various embodiments of the disclosure.

The enlarged view of FIG. 4D corresponds to an enlarged view of area A in FIG. 4B.

Referring to FIG. 4A, a method of manufacturing the board unit 210 may include a board preparation operation 401, a placement operation 402, a hot-shaping operation 403, and a secondary heating operation 404.

The board preparation operation 401 may be an operation of preparing the printed circuit board 211 for placement of the electrical components 209, and may be a preparation operation for forming the bonding layer 220 on the board. The placement operation 402 may be an operation of placing the electrical components 209 on the printed circuit board 211. The hot-shaping operation 403 may be an operation of shaping (or bending) the board unit 210 to have a curved shape by applying stress to the printed circuit board 211 and heating the board unit 210 to a predetermined temperature. The hot-shaping operation 403 may be performed, at least partially, in a heating unit (e.g., an autoclave). The secondary heating operation 404 may include an operation of heating the board unit 210 shaped to have a curved shape, to a melting temperature of the solder 222, so that bonding by the solder 222 is formed between the electrical components 209 and the wires of the printed circuit board 211. In various embodiments, the temperature at which the hot-shaping operation is performed may be equal to or higher than the glass transition temperature Tg of the polymer substrate layer 213 of the printed circuit board 211 and lower than the melting temperature of the solder 222 (e.g., from 80°C to 150°C).

Referring to FIG. 4B, in some embodiments, an operation of placing an ASA film 220a on the printed circuit board 211 on which the wiring layer 212 is formed (operation 501) (e.g., the board preparation operation 401 of FIG. 4A) may be performed. As illustrated in FIG. 4D described below, the ASA film 220a may be a film-shaped member in which solder alloy particles 222a are dispersed within a resin layer 211. An operation of placing the electrical components 209 on the printed circuit board 211 on which the ASA film 220a is placed (operation 502) (e.g., the placement operation 402 of FIG. 4A) may be performed. With respect to the printed circuit board 211 on which the electrical components 209 are placed, an operation of bending the printed circuit board 211 into a curved shape by applying stress F and heating the printed circuit board 211 to a predetermined temperature (e.g., from 80°C to 150°C, which may correspond to the glass transition temperature Tg of the polymer substrate layer 213 of the printed circuit board 211) (operation 503) (e.g., the hot-shaping operation 403 of FIG. 4A) may be performed. In some embodiments, the printed circuit board 211 may be heated within a heating unit (e.g., an autoclave) in a state elastically bent by stress, and thereby shaped into a curved shape. In other embodiments, the printed circuit board 211 may be heated within the heating unit and bent by stress in a softened state. That is, the bending and the heating may be performed simultaneously, or either one may be performed first. An operation of secondarily heating the hot-shaped board unit 210 to a predetermined temperature (e.g., from 150°C to 220°C, which corresponds to the melting temperature of the solder 222) (operation 504) (e.g., the secondary heating operation 404 of FIG. 4A) may be performed. By performing the secondary heating, electrical contacts may be formed by the solder 222 between the electrical components 209 and the wiring layer 212 of the printed circuit board 211. In some embodiments, as the secondary heating is performed, the resin layer 221 may be cured, thereby enhancing the bent shape retention force of the printed circuit board 211 by the resin layer 221. The secondary heating operation 504 may be continuously performed within the same heating unit as that used for the bending and heating. For example, after performing the operation of heating the polymer substrate layer 213 to the glass transition temperature Tg thereof in the autoclave, the secondary heating may be performed by continuously increasing the configured temperature of the autoclave to the melting temperature of the solder 222 (e.g., from 150°C to 220°C).

Referring to FIG. 4D, during the secondary heating operation, the solder alloy particles 222a dispersed in the ASA film 220a may be melted and move into the area between the wiring layer 212 and the electrical components 209 due to surface tension generated by the interfacial energy between the metal and the resin in the molten state, thereby forming electrical contacts. Additives such as a flux and/or a surfactant included in the ASA resin may promote the melting and movement of the above-described solder alloy particles 222a. In addition, due to the surface tension of the molten solder 222, the electrical components 209 may be aligned on the wiring layer 212. During the process of shaping the printed circuit board 211 into a curved shape, the electrical components 209 may become misaligned with the wiring layer 212. However, due to the surface tension of the molten solder 222 generated during the secondary heating, the electrical components 209 may be realigned with respect to the wiring layer 212. Accordingly, poor contacts of the electrical components 209, which may occur due to bending of the printed circuit board 211, may be prevented or minimized.

Referring to FIG. 4C, in other embodiments, an operation of forming, by pre-soldering, the solder 222 on the printed circuit board 211 in which the wiring layer 212 is formed, and placing the resin layer 221, which is a component of the bonding layer 220, on the printed circuit board 211 (operation 501) (e.g., the board preparation operation 401 of FIG. 4A) may be performed. Electrical components 209 may be placed on the printed circuit board 211 on which the pre-soldered solder 222 and the resin layer 221 is completely placed (operation 502) (e.g., the placement operation 402 of FIG. 4A). The bending and heating operation 503 (e.g., the hot-shaping operation 403 of FIG. 4A) may be referred to with respect to the description of FIG. 4B, provided there is no inconsistency.

In the secondary heating operation 504 (e.g., the secondary heating operation 404 of FIG. 4A), the pre-soldered solder 222 may be melted and form electrical contacts between the wiring layer 212 and the electrical components 209. The alignment between the electrical components 209 and the wiring layer 212 may be improved due to the surface tension of the molten solder 222.

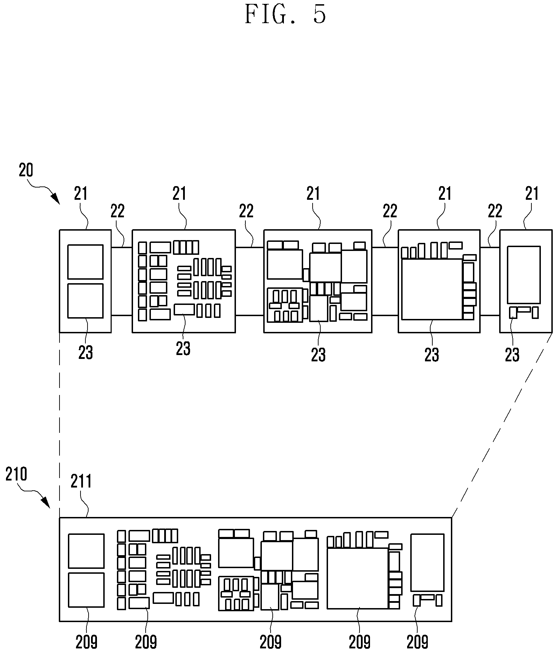

FIG. 5 illustrates plan views of board units of electronic devices according to an embodiment of the disclosure and a comparative example.

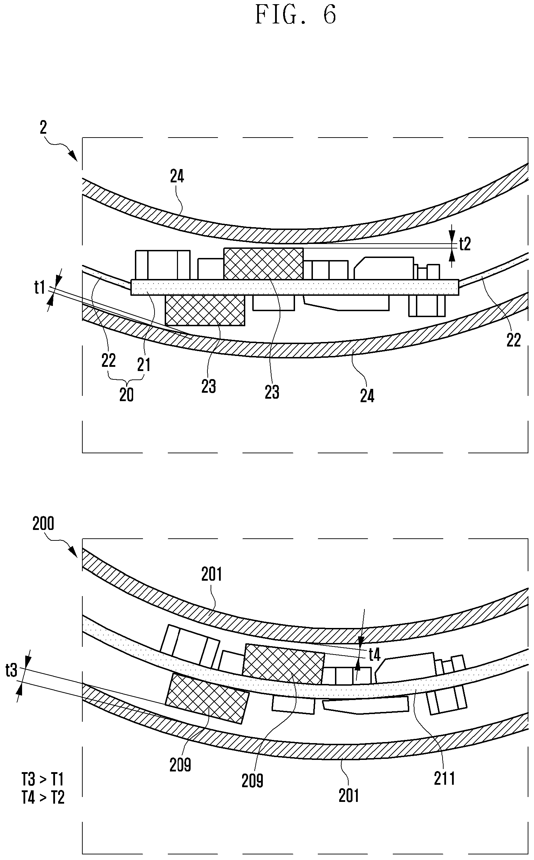

FIG. 6 illustrates enlarged cross-sectional views of the electronic devices according to an embodiment of the disclosure and an comparative example.

The comparative examples in FIGS. 5 and 6 correspond to an electronic device 2 using a rigid-flexible printed circuit board (RFPCB).

Referring to FIG. 5, in the board unit 20 according to the comparative example, due to the use of a rigid-flexible printed circuit board, the electrical components 23 are placed only on the rigid printed circuit board portions 21, and not on the flexible printed circuit board portions 22. In contrast, in the board unit 210 according to an embodiment of the disclosure, since the printed circuit board 211 itself has a curved shape and does not require separate flexible printed circuit board portions 22, the overall area of the board unit 210 may be reduced compared to that 20 of the comparative example when the same electrical components 209 are placed thereon.

Referring to FIG. 6, in the electronic device 2 according to the comparative example, since the rigid-flexible printed circuit board is used, the rigid printed circuit board portions 21 are not bent. As a result, clearance spaces T1 and T2 between the board unit 20 and the inner surface of the housing of the electronic device 2 may be insufficient. In such a case, it may be difficult to sufficiently protect the board unit 20 from impacts applied to the electronic device 2, and the size of the housing of the electronic device 2 may increase to compensate for this.

In contrast, in the electronic device 200 according to an embodiment of the disclosure, since the printed circuit board 211 has a curved shape, clearance spaces T3 and T4 between the board unit 210 and the inner surface of the housing of the electronic device 200 may be sufficiently secured. For example, referring to FIG. 6, in the electronic device 2 of the comparative example, the clearance spaces T1 and T2 between the board unit 20, including the electrical components 23 placed thereon, and the inner surface of the housing are smaller than the clearance spaces T3 and T4 of the electronic device 200 according to the disclosure. Accordingly, the size of the housing of the electronic device 200 may be reduced compared to the comparative example, and the wearing comfort of the electronic device 200 may be improved.

According to various embodiment of the disclosure, an electronic device 200 includes a board unit 210 on which at least one electrical component 209 is disposed. The board unit 210 may include a printed circuit board 211 including a wiring layer 212 and a polymer substrate layer 213 laminated on at least one surface of the wiring layer 212, the polymer substrate layer 213 being hot-shaped to have a curved shape, and a bonding layer 220 including a solder 222 that electrically bonds the electrical component 209 to at least a portion of the wiring layer 212, the bonding layer 220 being configured to fix the electrical component 209 on the board unit 210.

In various embodiments, the polymer substrate layer 213 may include a polymer material having a glass transition temperature lower than a melting temperature of the solder 222.

In various embodiments, the polymer substrate layer 213 may include a liquid crystal polymer (LCP) material.

In various embodiments, the printed circuit board 211 may include a built-up PCB formed by laminating at least one resin coated copper (RCC) foil.

In various embodiments, the bonding layer 220 may include a resin layer 221 configured to fix the electrical component 209 on the board unit 210, and the solder 222 may be at least partially embedded in the resin layer 221.

In various embodiments, the bonding layer 220 may be formed of an alignable self-assembly (ASA) film 220a including the resin layer 221 and solder alloy particles 222a dispersed in the resin layer 221.

In various embodiments, the ASA film 220a may include at least one of a flux and a surfactant.

According to various embodiments of the disclosure, a method of manufacturing a board unit 210 having a curved shape for an electronic device 200 may include a board preparation operation 401 of placing a bonding layer 220 including a solder 222 and a resin layer 221 on a printed circuit board 211 including a polymer substrate layer 213 and a wiring layer, a placement operation 402 of placing an electrical component 209 of the electronic device 200 on the printed circuit board 211 on which the bonding layer 220 is placed, a hot-shaping operation 403 of hot-shaping the printed circuit board 211 on which the electrical component 209 is placed into the curved shape, and a secondary heating operation of heating the printed circuit board 211 subjected to the hot-shaping operation 403.

In various embodiments, the hot-shaping operation 403 may be performed at a temperature equal to or higher than a glass transition temperature of the polymer substrate layer 213 and lower than a melting temperature of the solder 222.

In various embodiments, the hot-shaping operation 403 may be performed at a temperature ranging from 80°C to 150°C.

In various embodiments, the secondary heating operation may be performed at the melting temperature of the solder 222.

In various embodiments, the board preparation operation 401 may include placing an alignable self-assembly (ASA) film on the printed circuit board 211.

In various embodiments, the board preparation operation 401 may include an operation of forming the solder 222 on the printed circuit board 211 through pre-soldering, and an operation of forming the resin layer 221 on the printed circuit board 211.

Various embodiments of the disclosure provides a board unit 210 of an electronic device 200, which has a curved shape and on which an electrical component 209 is placed. The board unit 210 is positioned within the electronic device 200. The board unit 200 may include a printed circuit board 211 including a wiring layer 212 and a polymer substrate layer 213 laminated on at least one surface of the wiring layer 212, the polymer substrate layer 213 being hot-shaped to have a curved shape, and a bonding layer 220 including a solder 222 that electrically bonds the electrical component 209 to at least a portion of the wiring layer 212, the bonding layer 220 being configured to fix the electrical component 209 on the board unit 210.

In various embodiments, the polymer substrate layer 213 may include a polymer material having a glass transition temperature lower than a melting temperature of the solder 222.

In various embodiments, the polymer substrate layer 213 may include a liquid crystal polymer (LCP) material.

In various embodiments, the printed circuit board 211 may include a built-up PCB formed by laminating at least one resin coated copper (RCC) foil.

In various embodiments, the bonding layer 220 may include a resin layer 221 configured to fix the electrical component 209 on the board unit 210, and the solder 222 may be at least partially embedded in the resin layer 221.

In various embodiments, the bonding layer 220 may be formed of an alignable self-assembly (ASA) film including the resin layer 221 and solder alloy particles 222a dispersed in the resin layer 221.

In various embodiments, the ASA film 220a may include at least one of a flux and a surfactant.

The embodiments disclosed in the specification and drawings are provided merely to easily describe the technical features according to the embodiments disclosed herein and to help understanding of the embodiments disclosed herein and are not intended to limit the scope of the embodiments disclosed herein. Accordingly, the scope of various embodiments disclosed herein is to be construed as including all changes or modifications derived based on the technical idea of the various embodiments disclosed herein addition to the embodiments disclosed herein.

## Claims

1. An electronic device comprising:
a board unit on which at least one electrical component is disposed,
wherein the board unit comprises:
a printed circuit board comprising a metal wiring layer and a polymer substrate layer laminated on at least one surface of the metal wiring layer, the polymer substrate layer being hot-shaped to have a curved shape; and
a bonding layer comprising a solder that electrically bonds the electrical component to at least a portion of the metal wiring layer, the bonding layer being configured to fix the electrical component on the board unit.

2. The electronic device of claim 1, wherein the polymer substrate layer comprises a polymer material having a glass transition temperature lower than a melting temperature of the solder.

3. The electronic device of claim 1, wherein the polymer substrate layer comprises a liquid crystal polymer (LCP) material.

4. The electronic device of claim 1, wherein the printed circuit board comprises a built-up PCB formed by laminating at least one resin coated copper (RCC) foil.

5. The electronic device of claim 1, wherein the bonding layer comprises a resin layer configured to fix the electrical component on the board unit, and
wherein the solder is at least partially embedded in the resin layer.

6. The electronic device of claim 5, wherein the bonding layer is formed of an alignable self-assembly (ASA) film comprising the resin layer and solder alloy particles dispersed in the resin layer, and
wherein the ASA film comprises at least one of a flux and a surfactant.

7. A method of manufacturing a board unit having a curved shape for an electronic device, the method comprising:
placing a bonding layer comprising a solder and a resin layer on a printed circuit board comprising a polymer substrate layer and a wiring layer;
placing an electrical component of the electronic device on the printed circuit board on which the bonding layer is placed;
hot-shaping the printed circuit board on which the electrical component is placed into the curved shape; and
secondarily heating the hot-shaped printed circuit board.

8. The method of claim 7, wherein the hot-shaping is performed at a temperature equal to or higher than a glass transition temperature of the polymer substrate layer and lower than a melting temperature of the solder.

9. The method of claim 8, wherein the hot-shaping is performed at a temperature ranging from 80°C to 150°C.

10. The method of claim 7, wherein the secondary heating is performed at the melting temperature of the solder.

11. The method of claim 7, wherein the placing of the bonding layer comprises placing an alignable self-assembly (ASA) film on the printed circuit board.

12. The method of claim 7, wherein the placing of the bonding layer comprises: forming the solder on the printed circuit board through pre-soldering; and forming the resin layer on the printed circuit board.

13. A board unit of an electronic device, which has a curved shape and on which an electrical component is placed, the board unit being positioned within the electronic device, the board unit comprising:
a printed circuit board comprising a metal wiring layer and a polymer substrate layer laminated on at least one surface of the metal wiring layer, the polymer substrate layer being hot-shaped to have a curved shape; and
a bonding layer comprising a solder that electrically bonds the electrical component to at least a portion of the metal wiring layer, the bonding layer being configured to fix the electrical component on the board unit.

14. The board unit of claim 13, wherein the bonding layer comprises a resin layer configured to fix the electrical component on the board unit, and
wherein the solder is at least partially embedded in the resin layer.

15. The board unit of claim 14, wherein the bonding layer is formed of an alignable self-assembly (ASA) film comprising the resin layer and solder alloy particles dispersed in the resin layer, and
wherein the ASA film comprises at least one of a flux and a surfactant.
